# EUROPEAN PATENT APPLICATION

(11) **EP 2 034 048 A1**
(43) Date of publication of application: **11.03.2009**
(21) Application number: 07743342.3
(22) Date of filing: 14.05.2007
(51) Int. Cl.: C23C 16/46, H01L 21/205

(54) **HEATING APPARATUS**

(30) Priority: 17.05.2006 JP 2006138116
(71) Applicant: EAGLE INDUSTRY Co., Ltd., Tokyo 105-8587 (JP)
(72) Inventor: KOMINO, Mitsuaki, Tokyo 105-8587 (JP); SAITO, Kenji, Minato-ku Tokyo 105-8587 (JP)
(74) Representative: Feakins, Graham Allan
(86) International application number: PCT/JP2007/059907
(87) International publication number: WO 2007/132824

(57) **Abstract**

The present invention is to provide a heating apparatus available to reduce temperature quickly with efficient cooling effects in the case of reducing the temperature of a chamber or the like. A substrate processing apparatus 1 comprises a heating unit 100 in a chamber inner space 23 surrounded by a processing chamber 11 and a cover 12. The heating unit 100 is provided by a planer heating body 113 between an outer shell 111 and an inner shell 112. The heating unit generates heat when electricity is carried to the planar heat generating body 113, and heats the chamber inner space 23 to a desired temperature. At a boundary section of the outer shell 111 and the planar shaped heating body 113 of the heating unit 100, a cooling medium flow path 114 is spirally arranged along the circumference surface of the heating unit 100. At the time of reducing temperature, the cooling medium is permitted to flow in the cooling medium flow path 114 to forcibly cool the chamber inner space 23 and the substrate processing apparatus 1, and the temperature is rapidly reduced.

## Description

### TECHNICAL FIELD

This invention relates to a heating apparatus applied to a semiconductor manufacturing apparatus such as CVD (Chemical Vapor Deposition) apparatus, an etching apparatus and the like, which is preferable to heat substantially closed space such as a chamber inside, a container inside, a passage inside, a tube inside or a housing inside and the like.

### BACKGROUND ART

In a semiconductor manufacturing apparatus, for example, CVD apparatus and an etching apparatus and the like, arranging a wafer in a processing chamber, predetermined film forming treatment and etching treatment are conducted to the wafer by exposing the wafer to reaction gas or plasma and the like in high temperature environment. When such the treatment, treating gas and reaction by-products flowing in the chamber sublimate and change between both phases of gas and solid according to relation between pressure and temperature (sublimation curve), in the case of sublimation change from gas to solid, the reaction by-products deposit as solid and adhere to a wall face of an inside of the chamber and an exhaust pipe and the like, where the temperature thereof is below sublimation temperature. As a result, there is a case that pipes are blocked by the reaction by-products which is not preferable.
In order to eliminate such deposition and accumulation or to prevent the reaction by-products and to equally conduct film forming treatment (CVD) and etching treatment of the wafer, it is necessary to maintain comparatively higher temperatures of the chamber and the piping and to administrate and maintain thereof accurately.

Conventionally, for maintaining high temperature in the chamber and the like, for example, it has been taken measures to equip a heater at an outside of the chamber and the like (for example, refer to Japanese Patent Laid Open No. 2003-27240 (Patent Document 1)). However, according to the conventional measures wherein the heater is provided at the outside of the chamber, it is hard to heat an inner wall of the chamber uniformly, also it is hard to administrate and maintain the temperature of the chamber inside and the inner wall accurately.
Therefore, it has been proposed a method for administrating and controlling the temperature of inside of the chamber uniformly, efficiently and accurately by arranging a planar shaped heating unit along with the inner wall of inside of the chamber and the piping (refer to PCT International Publication W02004/105103(A1)(Patent Document 2)) . By this apparatus, it is possible to prevent deposition and accumulate of the reaction by-products as compared with the conventional apparatus. However, sublimation and accumulation of the reaction by-products cannot be prevented completely, even by such apparatus, it is necessary to execute in-situ cleaning during a certain period.
Patent Document 1: Japanese Patent Laid Open No. 2003-27240
Patent Document 2: WO2004/105103

By the way, in such semiconductor manufacturing apparatus, it is desired to improve an operation rate of the apparatus in view of improving a productivity rate of the semiconductor device. Specifically, it has been desired to decrease frequencies of failure occurring rate, maintenance cycles of the apparatus and to shorten a time required for failure and maintenance. Namely, it is desired that long lasting MTBF (Mean Time Between Failure) and shortening MTTR (Mean Time To Repair). At the above mentioned demand, in the conventional semiconductor manufacturing apparatus including an apparatus wherein a heating unit is arranged at an inside of the chamber as disclosed in Patent Document 2, it has been desired to shorten required times for one time maintenance or the in-situ cleaning since because the required time thereof is long-lasting.

Generally, when operating the film forming treatment (CVD) and etching, the inside of the chamber is maintained at its temperature more than 150°C, depending on circumstances and also chemistry of process, it is between at high temperature 500 °C to 600 °C. However, in the case of maintenance, it is necessary to return at normal temperature. Also, although executing the in-situ cleaning, although ClF₃, NF₃, F₂ gas and the like are used, etching ratio of these gases to the reaction by-products largely changes in response to environment temperatures, therefore it is necessary to use at temperature below 100°C, in actually. Namely, when executing the in-situ cleaning, it is necessary to decrease the environment temperature in the chamber below 100°C.
However, a semiconductor manufacturing apparatus of this kind has a high heat thermal insulating property so that maintaining high temperature in the chamber when treating and thermal a removal pathway is limited. Therefore, in case of reducing temperature once the temperature is increased or reducing temperature of a heat unit arranged in the chamber, it requires incomparably longtime than the temperature increasing.
As a result, a down time of the semiconductor manufacturing apparatus reaches quite long time, problems of decreasing operating rate of the apparatus and, for example, decreasing product ability of the semiconductor device and the like are occurred.

### DISCLOSURE OF INVENTION

### Problem to be Solved by the Invention

The present invention was made upon considering such problems and a purpose of the invention is to provide a heating apparatus which is available to maintain high temperature status uniformly and accurately by efficiently heating when it is desired to maintain the temperature of environment in the chamber and the like, for example as high temperature, and to cool rapidly by obtaining efficient cooling effects when it is desired to reduce the temperature.

### Means for Solving Problem

In order to solve the above mentioned problems, a heating apparatus arranged at an inner space of an optional processing chamber, a transforming path or a tube comprises a planar shaped heating body and a metallic covering portion for covering a circumference of said planar shaped heating body, wherein a cooling means is formed at an inner portion of said covering portion.
In the heating apparatus having such constitution, it is available to maintain high temperature status uniformly and accurately by efficiently heating, when it is desired to maintain the temperature of environment in the chamber and the like, for example as high temperature, and to cool rapidly by obtaining efficient cooling effects when it is desired to reduce the temperature.

As a preferable concrete example, said cooling means is formed on any one of an inside surface and an outside surface of said planar shaped heating body.
In the heating apparatus having such constitution, forced cooling in the chamber environment and the like is available efficiently and the temperature thereof can be reduced rapidly by comparatively easier constitution.

As the other preferable concrete example, said cooling means is formed on both of the inside surface and the outside surface of said planar shaped heating body.
In the heating apparatus having such constitution, the forced cooling in the chamber environment and the like is available efficiently further.

Preferably, in the heating apparatus of the present invention, said cooling means is a cooling medium flow path.
In the heating apparatus having such constitution, the forced cooling in the chamber environment and the like is efficiently available further.

The heating apparatus of the present invention may further comprise a supply pipe to supply the cooling medium to said cooling medium flow path and an exhaust pipe to exhaust the cooling medium from said cooling medium flow path;
a lead wire for applying electricity to said planar shaped heating body to be led out via said supply pipe and/or said exhaust pipe.
By the heating apparatus having such constitution, it is possible to eliminate the apparatus being complicated structure which is preferable, since it is not necessary to provide new components or a port for extracting the lead wire for applying electricity.

The heating apparatus of the present invention may further comprise a sensor for detecting a temperature at a predetermined position of said heating device, wherein;
a lead wire of said sensor is led out via said supply pipe and/or said exhaust pipe.
By the heating apparatus having such constitution, it is possible to eliminate the apparatus being complicated structure at this point which is preferable, since it is not necessary to provide new components or a port for extracting the lead wire of the sensor.

As a preferable specific example, in the heating apparatus of the present invention, said cooling medium flow path is a groove formed at a boundary section of said covering portion against said planar shaped heating body.
By the heating apparatus having such constitution, a cooling medium flow path can be formed easily and effectively, as a result, the force cooling of the environment of the inner chamber can be made efficiently, and the temperature thereof can be reduced rapidly.

As a preferable specific example, the heating apparatus of the present invention is formed as cylindrical shape, said cooling medium flow path is formed as a helical shape along the circumference surface of said heating apparatus unit or a plurality ring shape, one portion of said plurality of ring shape communicates through each other.
By the heating apparatus having such constitution, in a cylindrical shape apparatus, the cooling medium can be flown to whole region thereof efficiently, thereby the force cooling of the environment of the inner chamber is available efficiently, and the temperature thereof can be reduced rapidly which is preferable.

As the other preferable specific example of the heating apparatus, wherein;
said heating apparatus is formed as planar shape, said cooling medium flow path is formed as spiral shape to said heating apparatus or a plurality of annular shape, one portion of said annular shape communicates through each other.
By the heating apparatus having such constitution, in an apparatus having planar shape, the cooling medium can be flown to whole region thereof efficiently, thereby, the force cooling of the environment of the inner chamber is available efficiently, and the temperature thereof can be reduced rapidly which is preferable.

### BRIEF DESCRIPTION OF DRQWINGS

[Fig. 1] Fig. 1 schematically shows a constitution of a substrate processing apparatus of a first embodiment of the present invention.
[Fig. 2] Fig. 2 schematically shows a constitution of a substrate processing apparatus of a second embodiment of the present invention.
[Fig. 3A] Fig. 3A shows a shape of an outer shell of a planar shaped heating body of the substrate processing apparatus shown in Fig. 2, and shows a constitution of a cooling medium flow path formed on the heating unit.
[Fig. 3B ] Fig. 3B shows a shape of an outer shell of a cylindrical shape heating unit of the substrate processing apparatus shown in Fig. 2, and shows a constitution of a cooling medium flow path formed on the heating unit.
[Fig. 4] Fig. 4 schematically shows a constitution of a heating unit as a third embodiment of the present invention.
[Fig. 5] Fig. 5 schematically shows a constitution of a heating unit as a fourth embodiment of the present invention.

### BEST MODE FOR CARRYING OUT THE INVENTION

### First Embodiment

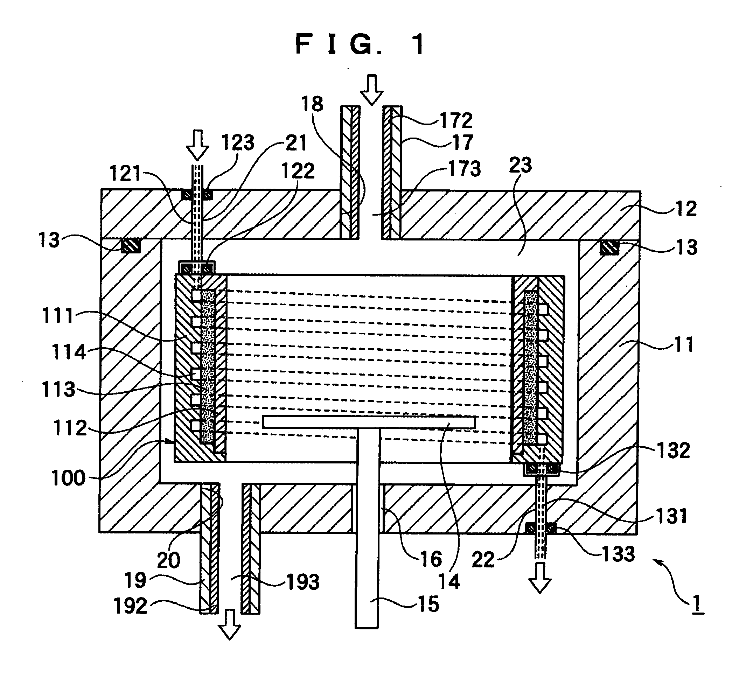

A first embodiment of the present invention is explained with reference to Fig. 1.
In the present embodiment, a substrate processing apparatus used for CVD (Chemical Vapor Deposition) and the like in which a heating apparatus according to the present invention is provided.
Fig. 1 is a main section cross sectional view of the substrate processing apparatus.

As shown in Fig. 1, a substrate processing apparatus includes a processing chamber 11 to form a space (a chamber inner space) 23 for applying desired treatment to a thrown semiconductor wafer under a desired environment, a cover 12, a susceptor 14 to which a wafer as a treating object is loaded thereto in the chamber inner space 23, a process gases supply pipe 17 to supply treating gas to the chamber inner space 23, an exhaust pipe 19 to exhaust the gas of the chamber inner space 23 and a heating unit 100 according to the present invention to heat the chamber inner space 23.

The processing chamber 11 is a cylindrical shape container having an upper opening portion. an exhaust opening 20 to which the exhaust pipe 19 is connected, an opening 16 for passing a supporting axis of the susceptor 14 and an opening 22 for through a cooling medium exhaust pipe 131 of the heating unit are formed at a bottom section of the processing chamber 11. Also, an O-ring 13 as a sealing member is provided at an upper edge face of an annular shape side face of the processing chamber 11. Also, a transporting path for inlet and outlet the wafer to the processing chamber 11 is formed on a side face of the processing chamber 11.

The cover 12 is connected so as to freely open and close an upper portion of the processing chamber 11 having the above mentioned structure, the upper opening of the processing chamber 11 is closed by loading the cover 12 to the upper edge face of the processing chamber 11 and the chamber inner space 23 is closed. At this time, as the O-ring 13 is interposed at a connecting portion of the processing chamber 11 and the cover 12, the chamber inner space 23 is sealed. A process gases supply opening 18 to which the process gases supply pipe 17 is connected, and an opening 21 so as to pass the cooling medium supply pipe 121 of the heating unit 100 are formed on the cover 12.

The susceptor 14 is supported as movable vertically and rotatably by a supporting axle 15 which passes the opening 16 of the bottom section of the processing chamber 11. The supporting axis 15 is connected with an outer driving mechanism which is not shown, and is moved vertically and rotatably. At the opening 16 of the bottom portion of the processing chamber 11 to which the supporting axis passes through, for example, a magnetic fluid sealing device and the like are provided, thereby the inside and outside of the chamber 11 are sealed.

The process gases supply pipe 17 is connected with the process gases supply opening 18 formed on the cover 12 to supply desired reaction gas and the like to the chamber inner space 23. In the substrate processing apparatus of the present embodiment, a process gases supply pipe heating unit 172 according to the present invention is provided on the process gases supply pipe 17 along an inner wall thereof so as to heat an inside of the process gases supply pipe 17. With respect to the process gases supply heating unit 172, it will be specified later.

One end of the exhaust pipe 19 is connected with the exhaust opening 20 formed at the bottom section of the processing chamber 11, the other end is connected with exhaust means such as a turbo molecular pump (TMP) and the like which is not shown, when operating vacuum drawing the chamber inner space 23 or operating desired treatment by circulating desired reaction gas in the chamber inner space 23, the pipe exhausts the gas in the chamber inner space 23. In the substrate processing apparatus of the present embodiment, an exhaust pipe heating unit 192 according to the present invention is provided on the exhaust pipe 19 along an inner wall thereof so as to heat an inside of the exhaust pipe 19. With respect to the exhaust heating unit 192, it will be specified later.

The heating unit 100 is used to heat the chamber inner space 23 so as to make a predetermined high temperature environment. Particularly, the heating unit 100 of the present embodiment is to heat the chamber inner space 23 appropriately, in addition, when maintaining and the like of the substrate processing unit 1, the processing chamber 11 and the inner space thereof 23 can be cooled during a short period, thereby, preparation for the next high temperature treatment and desired maintenance treatment can be made rapidly and efficiently.

As shown in drawings, the heating unit of the present embodiment 100 is a cylindrical shape device along the inner wall of the processing chamber 11, upper and lower ends thereof are opening statuses.
The heating unit 100 includes an outer shell 111, an inner shell 112 and a planar shaped heat generating body 113.

The outer shell 111 and the inner shall 112 are pair of metal sheets formed as cylindrical shape, respectively. Upper ends and lower ends of the outer shell 111 and the inner shell 112 are mutually connected with each other with interposing the planar shaped heat generating body 113, namely, the planar shaped heat generating unit 113 is sandwiched therebetween. By this constitution, the planar shaped heat generating body 113 becomes completely covered status by the outer shell 111 and the inner shell 112, namely, the planar shaped heat generating body 113 becomes enclosed status within an inner space formed by the outer shell 111 and the inner shell 112, the planar shaped heat generating body 113 is prevented to expose the treating gas and the like supplied to the chamber inner space 23.

Because the outer shell 111 and the inner shell 112 are respectively connected at their upper end portions and lower end portions, in the present embodiment, the outer shell 111 and the inner shell 112 are, at their upper end portions or lower end portions respectively, one or both ends thereof project to the other end, it is formed a shape which appropriately contact or connect with the other end. By connecting the outer shell 111, a spacer and the inner shell 112 respectively with interposing a member such as the spacer and the like between the outer shell 111 and the inner shell 112 at each of the upper end portion and the lower end portion of the heating unit 100, the planar shaped heat generating body 113 is sandwiched between the outer shell 111 and the inner shell 112 as well as the planar shaped heat generating unit 113 may be isolated from an external environment of the heating unit 100.

The heating unit 100 includes a cooling medium flow path 114 formed as a helical shape from an upper end portion to a lower end portion along a contact face of the outer shell 111 and the planar shaped heating body 113 at a cylindrical side face and the planar shaped heat generating unit 113. In the present embodiment, a groove 114 is formed as a helical shape at an inner face of the outer shell 111 (a face at a side contact with the planar shaped heat generating body 113) from the upper end portion to the lower end portion along a cylindrical circumferential face thereof. By connecting such outer shell 111 with the inner shell 112 with sandwiching the planer shaped heat generating body 113 at therebetween, the path 114 helically continuous from the upper end portion to the lower end portion along the cylindrical side face is formed at the contact face of the outer shell 111 and the planar shaped heat generating body 113.

An end portion of the upper end side of the cooling medium path 114 is connected with a cooling medium supply pipe 121 at an upper end face of the outer shell 111. The cooling medium supply pipe 121 is connected with the cooling medium flow path 114 at the upper end portion of a main body of the heating unit 100 by an attachment member 122. The attachment member 122 includes an O-ring to seal insides of the cooling medium flow path 114 and the cooling medium supply pipe 121 and the chamber inner space 23.

Also, an end portion of the lower end side of the cooling medium path 114 is connected with a cooling medium exhaust pipe 131 at a lower end face of the outer shell 111. The cooling medium exhaust pipe 131 is connected with the cooling medium flow path 114 at the lower end portion of a main body of the heating unit 100 by an attachment member 132. The attachment member 132 includes an O-ring to seal insides of the cooling medium flow path 114 and the cooling medium exhaust pipe 131 as well as the chamber inner space 23.
Note that, these cooling medium supply pipe 121 and/or cooling medium exhaust pipe 131 are preferable to be constituted as a removal portion to remove electric supply lead wires or lead wires of a sensor and the like from the chamber inner space 23 to an outside of the chamber.

Then, the cooling medium supply pipe 121 connected with the heating unit 100 is provided and fixed to the processing chamber 11 in the chamber inner space 23, and is led out to an outside of the processing chamber 11 through an opening 21 for the cooling medium supply pipe provided on the lid portion with a condition that the cover 12 closes the upper opening of the processing chamber 11. The cooling medium supply pipe 121 is connected with a cooling medium supply apparatus and the like which are not shown. At this time, the cooling medium supply pipe 121 is provided with the cover 12 by an attachment member 123 which includes O-ring to seal an inner portion of the opening 21 of cooling medium supply pipe, the chamber inner space 23 and the outside of the substrate processing apparatus 1.

Also, the cooling medium exhaust pipe 131 connected with the heating unit 100 is led out to the outside of the processing chamber 11 through an opening 22 for the cooling medium exhaust pipe provided on the bottom portion of the processing chamber 11 with a condition that the heating unit 100 is provided and fixed to the processing chamber 11 in the chamber inner space 23. The cooling medium exhaust pipe 131 is connected with an exhaust pump and the like which are not shown. At this time, the cooling medium exhaust pipe 131 is provided by an attachment member 133 which includes O-ring to seal an inner portion of the opening 22 of cooling medium exhaust pipe, the chamber inner space 23 and the outside of the substrate processing apparatus 1.

Note that, although it is not shown in the drawings, for example, a flange and the like as an attachment member is formed at an upper end portion of cylindrical shape of the heating unit 100 (e.g., an upper end portion of the outer shell 111). The heating unit 100 is provided and fixed to the processing chamber 11 by providing the flange between the processing chamber 11 and the cover 12 and tightening the processing chamber 11 and the cover 12 integrally.

By such constitution, the cooling medium is supplied to the main body of the heating unit 100 from the cooling medium supply pipe 121 at the time of cooling the substrate processing apparatus 1 (the chamber inner space 23). The cooling medium supplied from the cooling medium supply pipe 121 flows into the cooling medium flow path 114 and passes through the inside of the heating unit 100 and exhausted from the cooling medium exhaust pipe 131 with absorbing heat of the heating unit 100, namely, absorbing the heat of the chamber inner space 23.
Note that, as cooling medium, optional gas or liquid may be used. As a gas, it is preferable to use, for example, inactive gas such as air or nitrogen gas and argon gas. Also, as liquid, it is preferable to use Fluorinert (Trademark of 3M) and Galden (Trademark of SOLVAY S.A.).

The outer shell 111 and the inner shell 112 are formed by materials having high heat transfer efficiency and including carrion resistance property against the processing gas. In particular, although it is preferable that stainless steel (e.g., SU316) or aluminium sheet (e.g., A5052) and the like, ceramics and the like composed of any one of titanium, aluminium alloy, nickel cobalt alloy, or aluminium oxides, silicon carbide, aluminium nitride, silicon nitride, silicon oxide. Also, it is possible to maintain the corrosion resistance property by coating, a coating material in this case is preferably, alumina (Al₂O₃), SiC, AlN, Si₃N₄ or Y₂O₃ and the like.

Also, the planar shaped heat generating body 113 is composed of a resistance heating element such as a silicon rubber heater, a mica heater, a ceramics heater or polyimide heater and the like.
Also, in the present embodiment, a sheet thickness of the planar shaped heat generating body 113 is 1mm to 2mm.

Also, the heating unit 100 includes an electricity lead wire for applying electricity to the planar shaped heat generating body 113 as the other component. Also, as needed, the heating unit 100 includes, for example, a sensor such as thermocouple and lead wire thereof to detect a temperature of the planar shaped heat generating body 113 or a surface temperature of the heating unit 100. These lead wires are led out to the outside of the substrate processing apparatus 1 appropriately via a sealed through hole not shown which is provided on the processing chamber 11 or the cover 12. Alternatively, the cooling medium supply pipe 121 and/or the cooling medium exhaust pipe 131 may be composed as removal portions to led out the electricity lead wire or the lead wire of the sensor and the like from the chamber inner space 23 to the outside, which is preferable.

Note that, as previously mentioned, a transporting path for inlet and outlet the wafer is provided which is not shown. An opening portion not shown is provided in the processing chamber at a position corresponding to the transporting path of the processing chamber 11, so as to appropriately loading and unloading the wafer to a space which is further surrounded by the heating unit 100 in the processing chamber 11 via the transporting path.

As previously mentioned, the process gases supply pipe heating unit 172 and the exhaust pipe heating unit 192 are provided at insides of the process gases supply pipe 17 and the exhaust pipe 19 of the substrate processing apparatus 1. Basic structures of these process gases supply pipe heating unit 172 and the exhaust pipe heating unit 192 are same as the heating unit 100 other than a diameter of cylindrical cross section and a length of a cylindrical height direction.
Namely, although which are not shown respectively, the process gases supply pipe heating unit 172 and the exhaust pipe heating unit 192 are constituted by connecting an inner shell and an outer shell at cylindrical direction both end portions with sandwiching planar shaped heat generating bodies between the outer shell and the inner shell, a cooling medium flow paths which are helically continuing along cylindrical side faces are formed therein.

The process gases supply pipe heating unit 172 and the exhaust pipe heating unit 192 are connected with a plurality of units which are available to heat and cool individually to heat necessary portions of the process gases supply pipe 17 and the exhaust pipe 19. The electricity lead wire, the sensor lead wire, the cooling medium supply pipe and the cooling medium exhaust pipe and the like are led out appropriately from side faces of the process gases supply pipe 17 and the exhaust pipe 19 to the outside.

In the substrate processing apparatus 1 having such constitution, for example, after vacuum drawn of the chamber inner space 23 via the exhaust pipe 19, the process gases supply pipe heating unit 172 and the exhaust pipe heating unit 192 are electrically energized, an inner portion 173 of the process gases supply pipe 17 and an inner portion of the exhaust pipe 19 are heated. At this time, in the substrate processing apparatus 1 of the present embodiment, because the chamber inner space 23 is heated directly by the heating unit 100 arranged in the chamber inner space 23, it is possible to heat the chamber inner space 23 immediately and the chamber inner space 23 can be made as an objected temperature rapidly. Also, because it is possible to heat the chamber inner space 23 uniformly, it is available to administrate and maintain the temperature accurately due to good response. Namely, it is possible to administrate the temperature of chamber inner space 23 rapidly and accurately. Note that, by further providing heating means at an outside of the processing chamber 11, whole body of the substrate processing apparatus 1 including the processing chamber 11 and the cover 12 may be heated auxiliary.

When an inner portion 173 of the process gases supply pipe 17 and an inner portion 193 of the exhaust pipe 19 become desired high temperature status, the wafer which is a processing object is thrown into the chamber inner space 23 via the transporting path which is not shown of the substrate processing apparatus 1, then introducing desired gas via the process gases supply pipe 17 and exhausting the gas from the exhaust pipe 19 as needed to perform the procession such as film forming and the like by CVD. At this time, in the substrate processing apparatus 1 of the present embodiment, since an inner surface temperature of the chamber inner space 23 is maintained as uniformly and high temperature, it is possible to prevent deposition of the reaction by-products and to prevent particles generating according to deposition of the reaction by-products. Also, it is available to ensure an improvement of the film forming speed and an improvement of reaction speed. Further, because the inner portion 173 of the process gases supply pipe 17 and the inner portion 193 of the exhaust pipe 19 are high temperature status appropriately by the process gases supply pipe heating unit 172 and the exhaust pipe heating unit 192, at these piping portions, it is possible to prevent the deposition precipitation of the reaction gas component due to decreasing temperature. Namely, it is possible to prevent and restrict generating, adhesion and deposition of the reaction by-products at these piping portions. Also, as a result, for example, it is possible to prevent blockage of the exhaust opening 20 by the reaction by-products, or available to increase a time period until blockage sufficiently, MTBF (Mean Time Between Failure) of the apparatus can be extended and MTTR (Mean Time To Repair) can be shortened to increase the operating ration of the apparatus.

After application of the above mentioned procession with subsequently changing wafers as processing objects, according to reasons that processing of scheduled numbers of the wafer is finished, the reaction by-products are occurred, for maintaining other components in the chamber inner space or the like, in the case of adjusting or washing with stopping the substrate processing apparatus 1, in the substrate processing apparatus 1, the cooling medium is circulated in the cooling medium flow path 114 of the heating unit 100 after stopping heat generation of the heating unit 100, the process gases supply pipe heating unit 172 and the exhaust pipe heating unit 192. Namely, the cooling medium is filled to the cooling medium flow path 114 from the cooling medium supply pipe 121 of the heating unit 100, and discharging the cooling medium, which becomes high temperature due to absorbing the heat of heating unit 100 and the chamber inner space 23, from the cooling medium exhaust pipe 131. Thereby, the heating unit 100 is forced to cool and is cooled quickly. Also, a main body of the substrate processing apparatus 1 such as the processing chamber 11, the cover 12 or the like and the chamber inner space 23 can be cooled efficiently by cooling and decreasing the temperature of the heating unit 100, the temperature decreasing is made quickly than normal. Specifically, for example, when decreasing temperature of the main body of the substrate processing apparatus 1 from 150°C to 50°C, it takes four hours without conducting such cooling operation, the decreasing temperature can be made about one hour when operating such the cooling.
As a result, for example, the in-situ cleaning, maintenance or repair and the like can be operated quickly, TAT (Turn Around Time) of the apparatus can be shortened, so-called COO (Cost of Ownership) of the substrate processing apparatus 1 can be reduced.

### Second Embodiment

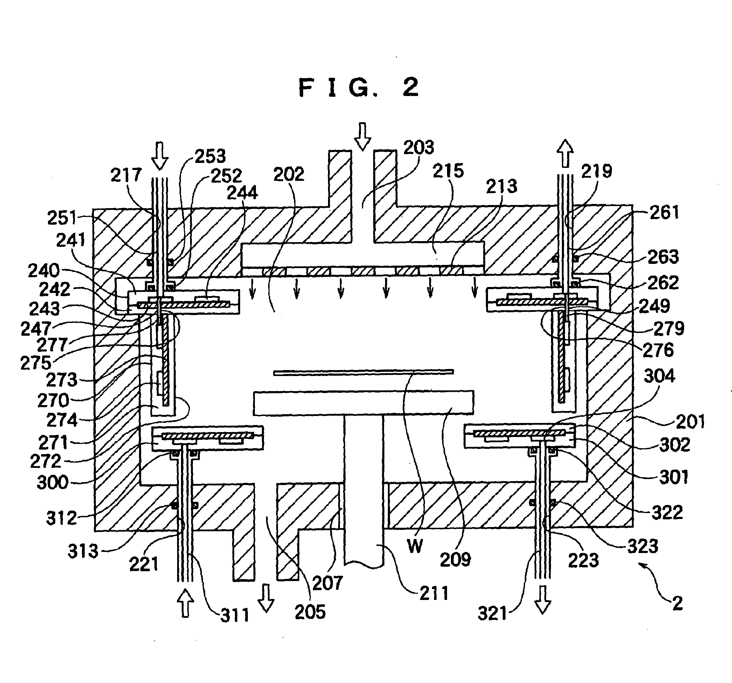

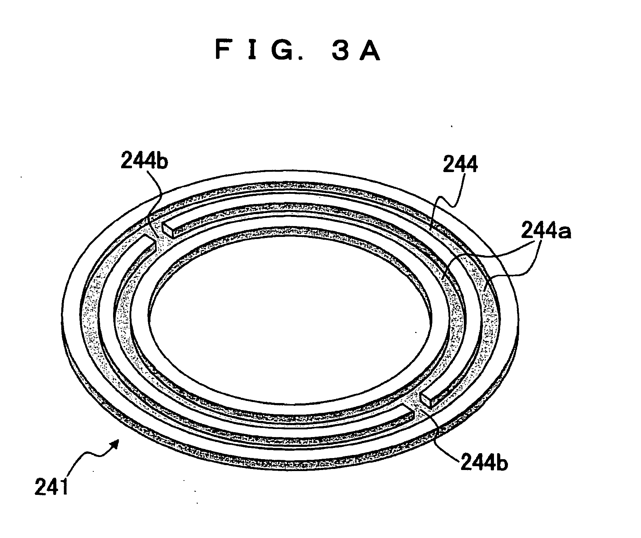

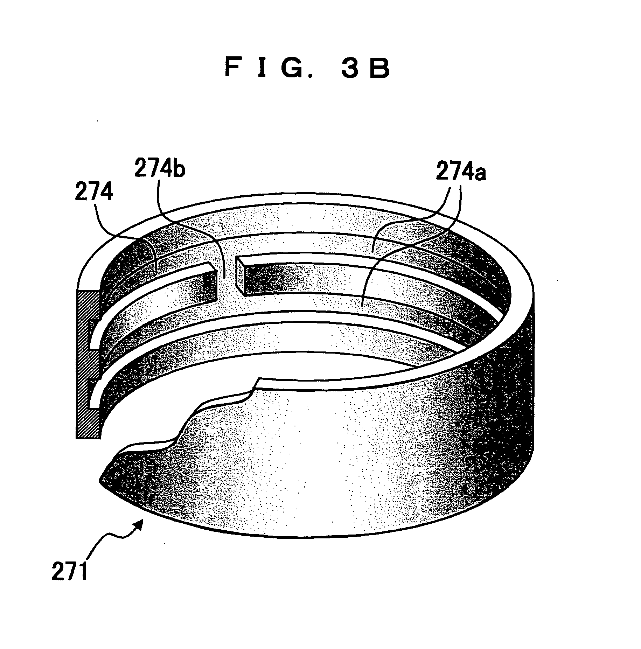

A second embodiment of the present invention is specified with reference to Fig. 2, Fig. 3A and Fig. 3B.
In the above mentioned first embodiment, the cylindrical shape heating unit 100 has been specified as a heating unit according to the present invention. In the second embodiment, it will be further specified that a flat plate heating unit as another form of the heating unit according to the present invention and the heating unit according to the present invention is applied to a substrate processing apparatus used for processing dry etching for a substrate and the like.

Fig. 2 is a main section cross sectional view of a substrate processing apparatus 2.
As shown in Fig. 2, the substrate processing apparatus 2 includes a processing chamber 201 to perform desired processing to a semiconductor wafer W under a desired environment, and a substrate stage 209 to hold the wafer W in an inner space 202 of the processing chamber 201.
Also, the substrate processing apparatus 2 includes a cylindrical heating unit 270 having same constitution of the heating unit 100 of the first embodiment, an annular shape upper portion heating unit 240 provided at an upper opening thereof and an annular shape lower portion heating unit 300 provided at a lower opening thereof.

The processing chamber 201 is a sealed container and is composed of, for example, aluminium, and a chamber inner space 202 is formed at an inside thereof. Although it is not shown in the drawings, an opening portion composed of an opening to which the wafer W is available to through, and a lid so as to open and close the opening is provided, a processing object W is loaded and unloaded to the chamber inner space 202 via the opening portion.

A process gases supply opening 203 is formed at an upper portion of the processing chamber 21 to supply treating gas and the like to the chamber inner space 202, and desired gas is supplied to the chamber inner space 202 via a process gases supply pipe connected with the opening portion which is not shown. Note that, although it is preferable to provide a process gases supply heating unit to the process gases supply pipe connected with the process gases supply opening 203 as similar to the first embodiment, since the constitution, function and effects are same as the first embodiment 1, explanation thereof are omitted.

At a portion where the process gases supply opening 203 is formed which is an inside upper face of the processing chamber 201, a gas introducing shower head 215 and an upper electrode 213 are provided.
The gas introducing shower head 215 is a hollow member in which a large number of small openings are formed at a face facing to a substrate stage 209, a gas supplied via the process gases supply opening 203 is introduced to an inner portion of the gas introducing shower head 215 and flows into the chamber inner space 202 from the small openings. Thereby, the processing gas is supplied with uniformly to the chamber inner space 202 from the face facing to the substrate stage 209.

The upper electrode 213 is an electrode member adhered to a surface where the small openings of the gas introducing shower head 215 are formed. The upper electrode 213 is electrically connected with an outside RF power applying apparatus which is not shown, a predetermined RF power is applied between a following mentioned a lower electrode of the substrate stage 209 by the RF power applying apparatus. Note that, in order to make available to flow the gas from the gas introducing shower head 215, small openings are formed on the upper electrode 213 corresponding to the small openings formed on the surface of the gas introducing shower head 215.

Also, at an upper portion of the processing chamber 201, an opening 217 is formed so as to pass a cooling medium supply pipe 251 of the heating unit 240, and an opening 219 is formed so as to pass a cooling medium exhaust pipe 261 of the heating unit 240.

An exhaust opening 205 to exhaust the gas of the chamber inner space 202 is formed at a bottom portion of the processing chamber 201, the gas in the chamber inner space 202 is exhausted via an exhaust pipe connected thereto which is not shown. Note that, although it is preferable to provide an exhaust pipe heating unit to the exhaust pipe connected with the exhaust opening 205 as similar to the first embodiment, since the constitution, function and effects are same as the first embodiment 1, explanation thereof are omitted.

Also, at an lower portion of the processing chamber 201, an opening 207 so as to pass a supporting axle of the substrate stage 209, an opening 221 so as to pass a cooling medium supply pipe 310 of a heating unit 300 and an opening 223 so as to pass a cooling medium exhaust pipe 320 of the heating unit 300 are formed.

The substrate stage 209 is supported as movable vertically and rotatably by a supporting axle 211 which passes the opening 207 of the bottom section of the processing chamber 201. The supporting axis 211 is connected with an outer driving mechanism which is not shown, and is moved vertically and rotatably. At the opening 207 of the bottom portion of the processing chamber 201 to which the supporting axis passes through, for example, a magnetic fluid sealing device and the like are provided and thereby the inside and outside of the chamber 201 are sealed.
A lower electrode and an electrostatic chuck are provided at an inside of the substrate stage 209, although they are not shown. The lower electrode is electrically connected with the outside RF power applying apparatus which is not shown by the RF power applying apparatus, and a predetermined RF power is applied between the upper electrode 213 and the lower electrode. Also, the electrostatic chuck are formed by a substrate, for example a dielectric and the like, to perform electrostatic deposition the wafer W by coulomb force of according to a RF power applied to the lower electrode or other applied RF power and to hold the processing object wafer W on the substrate stage 209.

The heating unit 204 is an annular shape and a flow path 244 of the cooling medium is formed in a concentric fashion, these are different from the heating unit 100 of the first embodiment, the other constitutions are similar with the above mentioned heating unit 100 of the above mentioned first embodiment.
Namely, the heating unit 240 includes an outer shell 241, an inner shell 242 and a planar shaped heat generating body 243 which are annular shape respectively and is constituted by that the planar shaped heat generating body 243 is sandwiched between the outer shell 241 and the inner shell 242 and connecting inner circumferential edges and outer circumferential edges of the inner shell 214 and the outer shell 242, respectively.

Then, the heating unit 240 includes the cooling medium flow path 244 at a contact face of the outer shell 241 and the planar shaped heat generating body 243.
The cooling medium flow path 244 is formed at first by that forming a groove at an inner face of the outer shell 241, namely at the contact face of the outer shell 241 and the planar heat generating body 243, then contacting the face to the planar shaped heat generating body 243, and the planar shaped heat generating body 243 is sandwiched between the inner shell 242 as mentioned above.

Fig. 3A shows a shape of the outer shell 241, and is a perspective view of the outer shell 241 viewing from a lower face side (a face of contact side of the planar shaped heat generating body 243 and the inner shell 243). Also, Fig. 3A shows a constitution of the cooling medium flow path 244 formed on the heating unit 240.
As shown in Fig. 3A, the cooling medium flow path 244 is formed by flow path portions 244a of a concentric fashion (annular shape) and radial direction flow paths 244b which connect the flow path 244a mutually. Note that, the flow path portions 244a may be formed as spiral shape. Also, the radial direction flow paths 244b are not limited two, more than three thereof may be made at equal intervals or an optional interval.

The cooling medium flow path 244is an opening status to the outside of the outer shell 241 at a predetermined position of a flow path of the most outer circumferential side which is shown in Fig. 2 (not shown in Fig. 3A). This opening is connected with the cooling medium supply pipe 251 at an outer face of the outer shell 241 . The cooling medium supply pipe 251 is connected with the cooling medium flow path 244 at an upper face of the heating unit 240 by an attachment member 252 having an O-ring to seal the insides of the cooling medium flow path 244 and the cooling medium supply pipe 251 with the chamber inner space 202.

Also, the cooling medium flow path 244 is an opening status to an outside of the outer shell 241 at an opposite side to a position where the cooling medium supply pipe 251 of the most outer circumferential flow path is connected, as shown in Fig. 2, this opening is connected with the cooling medium exhaust pipe 261 at the outer face of the outer shell 241. The cooling medium exhaust pipe 261 is connected with the cooling medium flow path 244 at the upper face of the heating unit 240 by an attachment member 262 having an O-ring to seal the insides of the cooling medium flow path 244 and the cooling medium exhaust pipe 261 with the chamber inner space 202.
Note that, these cooling medium supply pipe 251 and/or cooling medium exhaust pipe 261 are preferable to be constituted as removal portions for removing electrically supplying lead wires or lead wires of a sensor and the like from the chamber inner space 202 to an outside of the chamber.

Then, the cooling medium supply pipe 251 and the cooling medium exhaust pipe 261 are led out to the outside of the processing chamber 201 through an opening 217 for the cooling medium supply pipe and an opening 219 for the cooling medium exhaust pipe provided on the processing chamber 201. At this time, the cooling medium supply pipe 251 and the cooling medium exhaust pipe 261 are provided with the processing chamber 201 by attachment members 253 and 263 which include O-rings to seal an inner portion of the opening 217 of the cooling medium supply pipe, the chamber inner space 202 and an outer portion of the substrate processing apparatus 2, and an inner portion of the cooling medium exhaust pipe 219, the chamber inner space 202 and the outer portion of the substrate processing apparatus 2.

Also, in the cooling medium flow path 244 of the heating unit 240, an opening portion 247, which opens to a lower side or the heating unit 240 by penetrating the planar shaped heat generating body 243 and the inner shell 242, is formed at a predetermined position of the most outer circumferential flow path. This opening portion 247 is a constitution for the purpose or connecting the cooling medium flow path 244 of the heating unit 240 and a cooling medium flow path 274 of a heating unit 270, which is connected with a following mentioned opening portion 277 which is similar to the cooling medium flow path 274 formed on the heating unit 270.
Also, an opening portion 249 which opens to a lower side or the heating unit 240 by penetrating the planar shaped heat generating body 243 and the inner shell 242, is formed at a position opposite to the opening portion 274 of the most outer circumferential flow path of the cooling medium flow path of the heating unit 240. This opening portion 249 is also a constitution for the purpose or connecting the cooling medium flow path 244 of the heating unit 240 and a cooling medium flow path 274 of a heating unit 270, which is connected with a following mentioned opening portion 279 which is similar to the cooling medium flow path 274 formed on the heating unit 270.

The heating unit 270 is a similar constitution with the above mentioned heating unit 100 of the first embodiment. Namely, the heating unit 270 is a cylindrical apparatus along an inner wall of the processing chamber 201 and includes the outer shell 271, the inner shell 272 and the planar shaped heating body 273. The outer shell 271 and the outer shell 272 are a pair of metal plate formed cylindrical shape, respectively. A groove to form the cooling medium flow path 274 is formed on an inner face of the outer shell 271. By connecting the outer shell and the inner shell with interposing the planar shaped heating body 273, the heating unit 270 is constituted.

Here, in the heating unit 270, a shape of the cooling medium path 274 internally formed is different from the heating unit 100 of the first embodiment. With respect to the shape of the heating unit of the present embodiment, it will be specified with reference to Fig. 3B.
Fig. 3B is a partial cross sectional view showing a shape of the outer shell 271 of the heating unit 270, and showing a constitution of the cooling medium flow path formed at the heating unit 270.
As shown in Fig. 3B, the cooling medium flow path 274 includes circumferential direction flow path portions 274a which are equal diameter cylindrical (ring shape) flow paths provided concentrically in parallel, and flow path portions 274b formed toward a central axis direction to connect the flow paths provided in parallel. Note that, the circumferential direction flow path 274a may be formed as a spiral shape. Also, in the present embodiment, the center axis direction flow path 274b is formed at two position of the heating unit 270 which is cylindrical (in Fig. 3B, only one of them is shown), it is not limited thereto, more than three of them may be made at equal intervals or an optional interval.

As shown in Fig. 2, an opening portion 277 opens to an outer portion of the outer shell 271 is formed at a predetermined position of an upper portion of the outer shell in the cooling medium flow path 274 (not shown in Fig. 3B). The opening portion 277 connects the opening 247 formed at a corresponding portion of the upper heating unit to form a flow path 275 which connects the cooling medium flow path 244 of the heating unit 240 and the cooling medium flow path 274 of the heating unit 270.
Also, at a position circumferential direction opposed to the opening portion 277 of the upper end portion of the heating unit 270, a portion 279 of the cooling medium flow path 274 opens to the outer portion of the outer shell 271 is formed. This opening portion 279 form a flow path 276 which connects the cooling medium flow path 244 of the heating unit 240 and the cooling medium flow path 274 of the heating unit 270 by associating with an opening formed at a corresponding position of the heating unit 240.

Note that, it is preferable to constitute that an electricity lead wire or a lead wire of the sensor and the like according to the heating unit 270, which pass through these flow paths 275 and/or 276, and further pass through the cooling medium supply pipe 251 and/or the cooling medium exhaust pipe 261 connected with the heating unit 240, are removed from the chamber inner space 202 to the outside of the chamber.

The heating unit 300 corresponds to a constitution of the above mentioned heating unit 240 of which a diameter is slightly smaller and upside down arrangement, the constitution thereof is substantially same as the heating unit 240.
Namely, the heating unit 300 includes an outer shell 301, an inner shell 302 and a planar shaped heat generating body 303 which are annular shape respectively, and the heating unit is constituted by that the planar shaped heat generating body 303 is sandwiched between the outer shell 301 and the inner shell 302.
Then, the cooling medium flow path 304 is formed at a contact face of the outer shell 301 and the planar shaped heat generating body 303. The shape of the cooling medium flow path 304 is same as the cooling medium flow path 244 of the above mentioned heating unit 240 with reference to Fig. 3A.

Then, the cooling medium flow path 304 is an opening status to an outer portion of the cooling medium flow path 304 at a predetermined position of the outer circumferential flow path, as shown in Fig. 2, this opening is connected with the cooling medium supply pipe 311 at an outer face of the outer shell 301. The cooling medium supply pipe 311 is connected with the cooling medium flow path 304 at a lower face of the heating unit 300 by an attachment member 312 having an O-ring to seal the insides of the cooling medium flow path 304 and the cooling medium supply pipe 311 with the chamber inner space 202.

Also, the cooling medium flow path 304 is being an opening status to an outside of the outer shell 301 at an opposite side to a position where the cooling medium supply pipe 311 of the outer circumferential side flow path is connected, as shown in Fig. 2, this opening is connected with the cooling medium exhaust pipe 321 at the outer face of the outer shell 301. The cooling medium exhaust pipe 321 is connected with the cooling medium flow path 304 at the lower face of the heating unit 300 by an attachment member 322 having an O-ring to seal the insides of the cooling medium flow path 304 and the cooling medium exhaust pipe 321 with the chamber inner space 202. Note that, these cooling medium supply pipe 311 and/or cooling medium exhaust pipe 321 are preferable to be constitute as a removal portion for removing electrically supplying lead wires or lead wires of a sensor and the like according to the heating unit 300 from the chamber inner space 202 to an outside of the chamber.

Then, the cooling medium supply pipe 311 and the cooling medium exhaust pipe 321 are led out to an outside of the processing chamber 201 through an opening 221 for the cooling medium supply pipe and an opening 223 for the cooling medium exhaust pipe provided on the processing chamber 201. At this time, the cooling medium supply pipe 311 and the cooling medium exhaust pipe 321 are provided with the processing chamber 201 by attachment members 313 and 323 which include O-rings to seal an inner portion of the opening 221 of the cooling medium supply pipe, the chamber inner space 202 and an outer portion of the substrate processing apparatus 2, and an inner portion of the cooling medium exhaust pipe 223, the chamber inner space 202 and the outer portion of the substrate processing apparatus 2.

In the substrate processing apparatus 2 having such constitution of the present embodiment, since the chamber inner space 202 is heated by heating means to which the upper portion heating unit 240 and the lower portion heating unit 300 are added to the cylindrical heating unit 270, the chamber inner space 202 can be heated further quickly and the chamber inner space 202 can be made as an objected temperature rapidly. Further, by the provision of the heating unit 240 and the heating unit 300, the chamber inner space 202 can be heated uniformly further. And further preferable temperature administration can be made.

Also, when cooling the substrate processing apparatus 202 (the chamber inner space 202), the cooling medium is supplied from the cooling medium supply pipe 251 to the heating unit 240 and the heating unit 270, the cooling medium is supplied to from the cooling medium supply pipe 311 to the heating unit 300, respectively. Then, the cooling medium supplied to the heating units 240, 270 and 300 respectively flow into the cooling medium flow paths 244, 274 and 304 and pass through insides of the heating units 240, 270 and 300, with absorbing the heat of the heating units 240, 270 and 300, namely, absorbing the heat of the chamber inner space 202. Then, the cooling medium which absorbs the heat is exhausted from the cooling medium exhaust pipe 261 and the cooling medium exhaust pipe 321 to the outer portion of the substrate processing apparatus 2.

Therefore, in the case of adjusting or washing with stopping the substrate processing apparatus 2, in addition to the cylindrical heating unit 270, it is available to force cooling from the upper portion heating unit 240 and the lower portion heating unit 300, the reducing temperature of the chamber inner space 202 can be made by obtaining further efficient cooling effect. As a result, it is possible to progress the in-situ cleaning process and the like, for example, TAT (Turn Around Time) of the apparatus can be shortened further and so-called COO (Cost of Ownership) of the substrate processing apparatus 2 can be reduced further.

### Third Embodiment

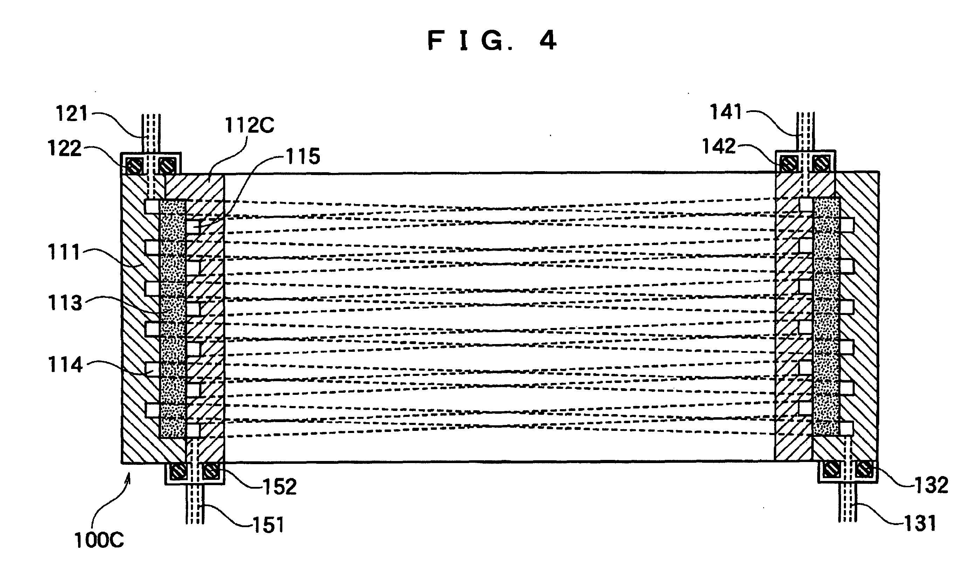

A third embodiment of the present invention is specified with reference to Fig. 4.
Fig. 4 shows a constitution of a heating unit according to the third embodiment of the present invention.
In the above mentioned apparatuses of the first embodiment and the second embodiment with reference to Fig. 1 to Fig. 3B, the heating units having cylindrical shape arranged at the chamber inner space are constituted that the cooling flow paths are formed only at a boundary of the outer shell and the planar shaped heating body. However, the cooling medium flow paths may be formed at the boundary of the inner shell and the planar shaped heating body, namely, at an inside of the planar shaped heating body.
The heating unit 100C having such shape will be specified as the third embodiment.

As shown in Fig. 4, the heating unit 100 includes an outer shell 111, an inner shell 112C and a planar shaped heating body 113. A main body of the heating unit 100 is constituted by connecting upper end portions and lower end portions of the outer shell 111 and the inner shell 112C respectively with sandwiching the planar shaped heating body 113 between the outer shell 111 and the inner shell 112C.

The heating unit 100C includes a cooling medium flow path 114 formed as a helical shape from an upper end portion to a lower end portion along a contact face of the outer shell 111 and the planar shaped heating body 113 at a cylindrical side face and the planar shaped heat generating body 113. Also, the heating unit 100C includes a cooling medium flow path 115 formed as a helical shape from an upper end portion to a lower end portion along a contact face of the inner shell 112C and the planar shaped heating body 113 at a cylindrical side face and the planar shaped heat generating body 113.
In the present embodiment, grooves 114 and 115 are formed as a helical shape at inner faces of the respective outer shell 111 and the inner shell 112C from the upper end portion to the lower end portion along a cylindrical circumferential face thereof. By connecting such outer shell 111 with the inner shell 112C with sandwiching the planer shape heat generating body 113 at therebetween, the paths 114 and 115 helically continuous from the upper end portion to the lower end portion along the cylindrical side face are formed at both faces of the planar shaped heat generating body 113.

An end portion of the upper end side of the cooling medium path 114 is connected with a cooling medium supply pipe 121 at an upper end face of the outer shell 111. The cooling medium supply pipe 121 is connected with the cooling medium flow path 114 at the upper end portion of a main body of the heating unit 100 by an attachment member 122 including an O-ring to seal insides of the cooling medium flow path 114 and the cooling medium supply pipe 121 and the chamber inner space 23.
Also, an end portion of the lower end side of the cooling medium path 114 is connected with a cooling medium exhaust pipe 131 at a lower end face of the outer shell 112C. The cooling medium exhaust pipe 131 is connected with the cooling medium flow path 114 at the lower end portion of a main body of the heating unit 100C by an attachment member 132 including an O-ring to seal insides of the cooling medium flow path 114 and the cooling medium exhaust pipe 131 and the chamber inner space 23.

Also, an end portion of the upper end side of the cooling medium path 115 is connected with a cooling medium supply pipe 141 at an upper end face of the inner shell 112C. The cooling medium supply pipe 141 is connected with the cooling medium flow path 115 at the upper end portion of a main body of the heating unit 100 by an attachment member 142 including an O-ring to seal insides of the cooling medium flow path 115 and the cooling medium supply pipe 141 and the chamber inner space 23.
Also, an end portion of the lower end side of the cooling medium path 115 is connected with a cooling medium exhaust pipe 151 at a lower end face of the inner shell 112C. The cooling medium exhaust pipe 151 is connected with the cooling medium flow path 115 at the lower end portion of a main body of the heating unit 100C by an attachment member 152 including an O-ring to seal insides of the cooling medium flow path 115 and the cooling medium exhaust pipe 151 and the chamber inner space 23.

These cooling medium supply pipes 121, 141 and the cooling medium exhaust pipes 131, 151 connected with the heating unit 100C are led out to an outer portion of the substrate processing apparatus 1 through openings corresponding to the respective pipes provided at the processing chamber 11 and the cover 12.

In the substrate processing apparatus 1C having such constitution, in the case of adjusting or washing with stopping the apparatus, the cooling medium which becomes high temperature with absorbing the heat of the heating unit 100C and the chamber inner space 23, is exhausted by supplying the cooling medium from the cooling medium supply pipes 121, 141 of the heating unit 100C to the both cooling medium flow paths 114, 115. Therefore, the forced cooling ability to the main body of the substrate processing apparatus 1C such as the chamber inner space 23, the processing chamber 11, the cover 12, the heating unit 100C and the like becomes considerably stronger as compared with a case that the only one cooling medium flow path is formed, thus, the temperature is decreased quickly by obtaining further efficient cooling effect. As a result, it is possible to progress the in-situ cleaning process and the like, for example, TAT (Turn Around Time) of the apparatus can be shortened further and so-called COO (Cost of Ownership) of the substrate processing apparatus 2 can be reduced further.

Note that, in the present embodiment, although helical directions of the cooling medium flow path 114 and the cooling medium flow path 115 are reverse direction as shown in Fig. 4, it may be same direction.
Also, in the present embodiment, against the two cooling medium flow paths 114 and 115, it is constituted that the cooling medium is supplied from the upper end portion and is exhausted from the lower end portion. However, in the two cooling medium flow paths, flow directions of the cooling medium may be opposite direction. If the cooling medium is flow like this, it is effective since the temperature of the heating unit 100C can be reduced uniformly from both ends of the upper end portion and the lower end portion of the heating unit 100.

### Fourth Embodiment

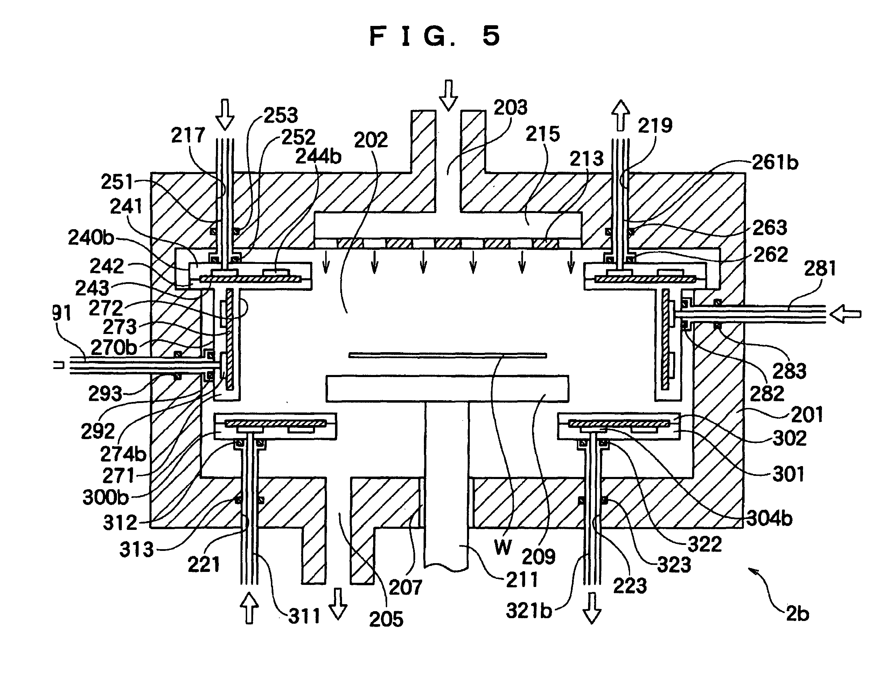

A fourth embodiment of the present invention is specified with reference to Fig. 5.
Fig. 5 shows a constitution of a substrate processing apparatus 2b as a fourth embodiment of the present invention.
Although a constitution of the substrate processing apparatus 2b of the present embodiment is almost same as the above mentioned substrate processing apparatus 2 with reference to Fig. 2, Fig. 3A and Fig. 3B, a constitution of cooling medium flow paths in respective heating units, and connecting method of a cooling medium supply pipe and a cooling medium exhaust pipe to the cooling medium flow paths are different from the substrate processing apparatus 2 of the second embodiment.

Namely, in the heating unit 270 of the substrate processing apparatus 2 of the second embodiment, the cooling medium flow path 274 of the heating unit 270 is connected with the cooling medium flow path 244 of the above annular shape heating unit 240 to form a cooling medium flow path which is integrally with the cooling medium flow path 244, also supplying and discharging the cooling medium have been conducted through the cooling medium exhaust pipe 251 and the cooling medium exhaust pipe 261 provided to the above heating unit 240.
However, in the substrate processing apparatus 2b of the present embodiment, as shown in Fig. 5, a cooling medium supply pipe 281 and a cooling medium exhaust pipe 291 which penetrate a side face of a processing chamber 201 to the heating unit 270b are provided, it is constituted that the cooling medium is supplied and exhausted directly from the cooling medium supply pipe 281 and the cooing medium exhaust pipe 291 to a cooling medium flow path 274a of the heating unit 270b.

The cooing medium supply pipe 281 and the cooling medium exhaust pipe 291 are respectively provided with the cooling medium flow path 274b, a chamber inner space 202 and an outer portion of the processing chamber 201 with appropriate sealing by attachment members 282, 283 and 292, 293 respectively having O-rings.
Also, the cooling medium flow path 274b of the heating unit 270b is formed as helically, for example, such as the cooling medium flow path 114 of the heating unit 100 of the first embodiment, the cooling medium supply pipe 281 is connected with an upper end portion thereof and the cooling medium exhaust pipe 291 is connected with a lower end portion thereof which is further preferable.
In the substrate processing apparatus 2b having such constitution, it is not necessary to provide openings (openings 247 and 249 in Fig. 2) for communicating a cooling medium flow path 244b to a lower side of the heating unit 240b. Also, in the heating unit 270b, it is not necessary to provide openings (openings 277 and 279 in Fig. 2) for communicating a cooling medium flow path 274b to an upper side.

Also, in the substrate processing apparatus 2b, the cooing medium flow path 244b of the heating unit 240b is formed as a spiral shape, and a cooling medium supply pipe 311 is connected to the most outer circumferential portion thereof and a cooling medium exhaust pipe 321b is connected to the most inner circumferential portion thereof.

The present invention may be worked by such embodiment.
Then, in the substrate processing apparatus 2b having such constitution, the chamber inner space 202 is heated by a cylindrical heating unit 270b, an upper portion heating unit 240b and a lower portion heating unit 300, it can be heated rapidly and uniformly and preferable temperature administration can be conducted.
Also, when the substrate processing apparatus 2b is cooled, the cooling medium can be supplied and exhausted via cooling medium supply pipes 251, 281, 311 and cooling medium exhaust pipes 261b, 291, 321b which are respectively individual to the heating unit 240b, the heating unit 270b and the heating unit 300b. Therefore, the chamber inner space 202 of the substrate processing apparatus 2b can be cooled rapidly, it is possible to progress the in-situ cleaning process and the like.

Also, in the heating unit 270b, the cooling medium flow path 274b is formed as a helical shape, the cooling medium flow path 244b and the cooling medium flow path 304b are formed as spiral shape in the upper heating unit 240b and the lower heating unit 300b, any of them, flowing directions of the cooling medium are clearly defined as one direction.
Therefore, it becomes the cooling medium flows smoothly, it can be made efficiently that heat absorption from wall faces of the heating unit 240b, the heating unit 270b and the heating unit 300b. Thus, it is possible to cool the chamber inner space 202 efficiently.

### OTHER VARIATIONS

Note that, the above mentioned embodiments are described for easily understanding of the present invention and not in any way meant to limit the present invention. Each elements disclosed in the present embodiments include all design around matters and equivalents as fall within a technical scope of the present invention, and optionally preferable various modifications are available.

For example, a supply opening to supply the cooling medium to the cooling medium flow path provided at the heating unit and an exhaust opening are not limited to one each, it may be a plurality of openings.
Also, a pitch of the cooling medium groove may be changed for partially cooling rapidly, and it may be changed as the most appropriate arrangement for rapid cooling.
Further, it may be constituted to turn the cooling medium supply and exhaust.

Also, in the above mentioned heating unit, means for cooling to cool the heating unit and the chamber inner space is that the cooling medium is flown in the cooling medium flow path provided at the heating unit. However, the means for cooling is not limited thereof, for example, it may be a method for providing Peltier element to the heating unit or it may be provided a heat pipe may to the heating unit and other optional method.

Also, in the above embodiments, although the present invention is applied to a semiconductor manufacturing apparatus such as a substrate processing apparatus or an etching apparatus and the like, the present invention can be applied to the other optional apparatus which is not limited to a semiconductor manufacturing apparatus. The heating apparatus of the present invention can be applied preferably to optional portions, where necessary to be high temperature environment, of an apparatus in which some degree of a space is defined substantially, such as a chamber, a furnace, a chamber, a container or a tube, a cylinder and the like or a part thereof.

### INDUSTRIAL APPLICABILITY

The heating apparatus of the present invention can be applied to the semiconductor manufacturing apparatus such as a substrate processing apparatus, etching apparatus and the like. Also, if it is necessary to heat an inner wall face which defines a flow path or a space directly from an inside, it may be used to the other apparatus and the like.

## Claims

1. A heating apparatus arranged at an inner space of an optional processing chamber, a transferring path or a tube comprising;
a planar shaped heating body,
a metallic covering portion for covering circumference of said planar shaped heating body, and
a cooling means formed at an inner portion of said covering portion.

2. The heating apparatus as set forth in claim 1, wherein;
said cooling means is formed on any one of an inside surface or an outside surface of said planar shaped heating body.

3. The heating apparatus as set forth in claim 1, wherein;
said cooling means is formed on both of the inside surface and the outside surface of said planar shaped heating body.

4. The heating apparatus as set forth in any one of claims 1 to 3, wherein;
said cooling means is a cooling medium flow path.

5. The heating apparatus as set forth in claim 4 further comprising;
a supply pipe to supply the cooling medium to said cooling medium flow path and an exhaust pipe to exhaust the cooling medium from said cooling medium flow path, wherein;
a lead wire for applying electricity to said planar shaped heating body is led out via said supply pipe and/or said exhaust pipe.

6. The heating apparatus as set forth in claim 5 further comprising;
a sensor for detecting a temperature at a predetermined position of said heating device, wherein;
a lead wire of said sensor is led out via said supply pipe and/or said exhaust pipe.

7. The heating apparatus as set forth in any one of claims 4 to 6, wherein;
said cooling medium flow path is a groove formed at a boundary section of said covering portion against said planar shaped heating body.

8. The heating apparatus as set forth in any one of claims 4 to 7, wherein;
said heating device is formed as cylindrical shape,
said cooling medium flow path is formed as a helical shape or a plurality of ring shape along a side wall of said heating apparatus, and
a portion of said plurality of ring shape communicates through each other.

9. The heating apparatus as set forth in any one of claims 4 to 7, wherein;
said heating apparatus is formed as a planar shaped,
said cooling medium flow path is formed as a spiral shape or a plurality of annular shape in said heating apparatus, and
a portion of said annular shape communicates through each other.
